# FASCICULE DE BREVET EUROPEEN

(11) **EP 3 635 414 B1**
(45) Date de publication et mention de la délivrance du brevet: **20.12.2023**
(21) Numéro de dépôt: 18712805.3
(22) Date de dépôt: 05.03.2018
(51) Int. Cl.: G01R 15/18, G01R 33/04, G01R 33/00, H01F 1/00, B82Y 25/00

(54) **CAPTEUR DE COURANT DC/AC ISOLÉ À EFFET NÉEL® INTÉGRÉ DANS UN PCB**
IN EINE LEITERPLATTE INTEGRIERTER NÉEL-EFFECT®-ISOLIERTER DC/AC-STROMSENSOR
NÉEL-EFFECT® ISOLATED DC/AC CURRENT SENSOR INCORPORATED IN A PCB

(30) Priorité: 06.03.2017 FR 1751776
(43) Date de publication de la demande: 15.04.2020
(73) Titulaire: Neelogy, 37550 Saint-Avertin (FR)
(72) Inventeur: CIMA, Lionel, Fabien, 37540 Saint-Cyr-sur-Loire (FR)
(74) Mandataire: Gevers & Orès
(86) Numéro de dépôt international: PCT/EP2018/055323
(87) Numéro de publication internationale: WO 2018/162400

(56) Documents cités:
- WO-A1-2011/018533
- WO-A1-2013/045778
- FR-A1- 3 034 526
- US-A1- 2006 113 987
- US-A1- 2007 216 408
- K. Gutierrez ET AL: "PCB Design Guidelines for 0.5mm Package-on-Package Applications Processor, Part I", , 1 juin 2010 (2010-06-01), XP055441379, Extrait de l'Internet: URL:http://www.ti.com/lit/an/sprabb3/sprab b3.pdf [extrait le 2018-02-02]
- DU MEIZHU ET AL: "Via design in multi-layer PCB", ENVIRONMENTAL ELECTROMAGNETICS, 2003. CEEM 2003. PROCEEDINGS. ASIA-PAC IFIC CONFERENCE ON HANGZHOU, CHINA NOV. 4-7, 2003, PISCATAWAY, NJ, USA,IEEE, 4 novembre 2003 (2003-11-04), pages 94-98, XP010695889, ISBN: 978-7-5635-0802-0
- Unknown: "Designing with Vias", , 1 janvier 2015 (2015-01-01), XP055441384, Extrait de l'Internet: URL:http://www.royalcircuits.com/images/Vi as_White_Paper_2015.pdf [extrait le 2018-02-02]
- VOURC'H ERIC ET AL: "Novel Magnetic Field and Current Sensors Based on Superparamagnetic Transducers", SENSOR LET, AMERICAN SCIENTIFIC PUBLISHERS, US, vol. 7, no. 3, 1 juin 2009 (2009-06-01), pages 293-298, XP009134380, ISSN: 1546-198X, DOI: 10.1166/SL.2009.1063

## Description

La présente invention se rapporte à un dispositif de mesure de champ magnétique et plus particulièrement pour la mesure de courants continu et/ou alternatif d'un conducteur primaire. Le domaine de l'invention est celui de la mesure des champs magnétiques (magnétomètres) ou de la mesure de courants électriques par l'intermédiaire de leurs champs magnétiques (transducteur de courant sans contact).

Dans le domaine des capteurs de courant DC on connaît les « shunt » qui présentent une grande immunité aux courants perturbateurs et permettent de mesurer des courants précisément mais ils ne sont pas isolés naturellement. L'utilisation d'un shunt requiert une électronique d'isolation qui en général est coûteuse et volumineuse, peu robuste en environnement contraint (notamment à haute température). Pour des applications de forte tension (>50V), il existe des solutions à isolation optique. En général le matériau utilisé pour la mesure est un matériau dont la résistivité est à constante de dérive thermique sensiblement nulle (constantan par exemple). Parfois on utilise directement du cuivre, il faut alors prévoir une compensation des dérives thermiques, ce qui complique la mesure et la rend en général moins précise. Parmi les défauts du shunt, on peut noter la présence d'une chute de tension et la dissipation de puissance par effet Joule. Pour un capteur de 1000A on a typiquement 10µOhm de résistance et ainsi 10W de dissipation thermique. L'une des conséquences est la grande difficulté d'utilisation d'un shunt dans un système compact du fait de son auto-échauffement.

En général un shunt est également assez volumineux pour permettre justement la dissipation de température sans dépasser la température maximale de celui-ci.

Finalement, le shunt a une bande passante très limitée par les effets autoinductifs, sauf dans le cas des shunts aselfiques dont les volumes, masse et coûts sont prohibitifs en dehors de quelques applications très rares de métrologie.

Les capteurs à effet Hall en boucle ouverte sont peu précis et très sensibles aux courants perturbateurs. Pour améliorer leur immunité, on utilise souvent des blindages magnétiques qui introduisent des défauts supplémentaires : ils sont sujets à de fortes rémanences magnétiques qui dérivent dans le temps et en température.

Les capteurs à effet Hall à flux nul sont précis et reposent sur l'utilisation d'un noyau magnétique qui fait office de blindage magnétique et de canaliseur de champ. Ils sont cependant également sujets à une dérive de la rémanence magnétique dans le temps et en température. Ils sont également gros et encombrant du fait de la présence du noyau en matériau magnétique nécessaire à la canalisation du flux magnétique et au blindage. La limite de fonctionnement à haute température est souvent imposée par le noyau ferromagnétique.

La technologie Flux Gate est très sensible et précise mais présente une extrême sensibilité à la diaphonie et aux environnements perturbés du fait de la haute perméabilité de son matériau magnétique. La technologie nécessite alors des solutions de blindage lourdes et volumineuses pour éviter la saturation locale du noyau transducteur sous l'effet d'un champ magnétique.

Les technologies GMR (Giant MagnetoResistance) et/ou AMR (Anisotropic MagnetoResistance), voire TMR (Tunnel MagnetoResistance) sont relativement sensibles et précises lorsqu'elles utilisent le principe de flux nul. Elles s'intègrent facilement dans un circuit intégré, sauf le bobinage de compensation qui pose problème pour les forts champs et donc limite la gamme de courant applicable. Du coup, elles sont relativement sensibles aux phénomènes de diaphonie et elles présentent aussi une dérive de leur offset magnétique de par la nature ferromagnétique de leur transducteur.

Les capteurs de courant à fibre optique (FOCS en anglais) reposent sur l'effet Faraday. Ils sont très performants pour la mesure de très forts courants (jusque 600kA). Ils présentent une excellente immunité à la diaphonie, et d'excellentes performances lors d'un fonctionnement à flux nul. Celui-ci introduit une forte consommation de puissance pour les forts courants. Cependant, les FOCS ne sont pas applicables a priori pour les besoins d'intégration car ils sont relativement volumineux et nécessitent d'entourer le conducteur primaire.

Les capteurs de courant de type transformateur (à air de type « Rogowski » ou CT à noyau magnétique) sont relativement peu sensibles à la diaphonie, mais ils ne permettent pas de mesurer les composantes DC.

Par ailleurs, pour la plupart des technologies utilisées, les variations brusques de la tension primaire (dV/dt) provoquent des injections de courants parasites qui peuvent être rédhibitoires au niveau de l'électronique du capteur (au mieux saturation des étages de mesure, au pire destruction). C'est particulièrement sensible dans le cas du shunt. Certaines technologies comme le transformateur (CT, Rogowski ou Hall ou Flux Gate) permettent l'utilisation d'un écran électrostatique car la mesure de champ magnétique est réalisée dans un tore à l'extérieur du conducteur primaire.

L'Effet Néel@ est très précis. On appelle Effet Néel@ la technologie décrite dans le brevet n° FR 2,891,917 et reposant sur l'utilisation d'un bobinage et d'un composite magnétique sans rémanence B(H) dont la dérivée troisième à l'origine présente un extremum (par exemple un composite superparamagnétique). La technologie Effet Néel@ est peu sensible aux champs extérieurs du fait de la faible perméabilité de leur matériau magnétique. Ils existent sous une forme « universelle » flexible de type Rogowski pour mesurer les courants continus (brevet FR 2,931,945). Cette topologie présente une forte immunité à la diaphonie en s'appuyant sur le théorème d'ampère et en faisant une mesure de circulation du champ magnétique sur un contour extérieur sensiblement fermé. Cette topologie présente les mêmes avantages et inconvénients que les autres technologies du point de vue de l'intégration : ils sont gros car ils doivent entourer le conducteur primaire et ils présentent une forte consommation électrique pour fonctionner à flux nul.

Il a été décrit également des topologies compactes de capteurs à Effet Néel^{®} reposant sur une mesure directement sur un busbar voire même à l'intérieur d'un busbar, ceci afin de permettre une réduction importante de la consommation malgré un fonctionnement à flux nul (demandes de brevet français n° 1158584 et n° 1162100). Il est cependant difficile avec ces topologies de pouvoir assurer une bonne tenue en tension, de rajouter en plus un écran électrostatique et de présenter une forte immunité à la diaphonie.

On connaît également la demande de brevet français n° 15 52694 publieé sous FR3034526 A1 décrivant une topologie compacte de capteur à Effet Néel@ reposant sur l'utilisation d'un composant de conversion IpHp et d'un transducteur de champ constitué de deux paires différentielles montées en antiparallèle.

La présente invention a pour but d'amélioration les capteurs à Effet Néel@ existants en les rendant plus compacts et pour une utilisation avec une grande bande passante.

La présente invention a aussi pour but un capteur de courant permettant une mesure linéaire et à faible dérive thermique sur une large gamme de fréquence.

On atteint au moins l'un des objectifs avec un capteur de courant comprenant au moins un circuit primaire destiné à conduire le courant à mesurer, et un circuit secondaire comprenant au moins quatre transducteurs à Effet Néel@ constitués chacun d'un bobinage et d'un noyau superparamagnétique. Selon l'invention, le capteur de courant est conçu à base de circuit imprimé, le circuit primaire comprenant au moins deux pistes métalliques distinctes composées d'un même métal et connectées entre elles par au moins deux via constitués du même métal que les pistes métalliques.

Par via on entend une connexion électrique entre deux couches d'un circuit imprimé, « vertical interconnect access » en anglais.

Les deux via selon l'invention constituent notamment respectivement une entrée et une sortie d'une zone de distribution de courant homogène entre les deux via.

Le capteur de courant selon l'invention permet de réaliser des mesures de manière linéaire et à faible dérive thermique sur toute une gamme fréquentielle.

L'invention permet de réaliser une conversion du courant à mesurer en un champ magnétique en introduisant éventuellement un effet de diviseur de courant. Pour cela on peut utiliser :
- des pistes métalliques ou plaques conductrices générant des champs essentiellement orthogonaux aux axes des bobines et qui ne contribueront ainsi pas à la mesure et
- des pistes métalliques ou plaques conductrices générant des champs essentiellement colinéaires aux axes des bobines et qui contribueront ainsi à la mesure.

On obtient ainsi une capacité de design de capteur de courant permettant de fonctionner à flux nul y compris pour des niveaux de courants très élevés (> 10A, jusque 100A, voire 1000A, voire 10kA et au-delà).

Il est intéressant d'utiliser le processus de fabrication des circuits imprimés (« Printed Circuit Board » en anglais) pour réaliser ces conducteurs primaires, soit avec des barres de cuivres et des inserts dans des PCB, soit directement dans des PCB, soit une combinaison des deux.

L'intérêt d'une telle réalisation selon l'invention, qui consiste à utiliser une liaison métallique, notamment cuivrée, sans soudure entre les différentes barres primaires, est d'éliminer la notion de résistance de contact qui introduit des phénomènes parasites en fonction du temps (vieillesse) ou de la température. De façon avantageuse, cette liaison métallique est réalisée sans soudure, avec par exemple des liaisons réalisées par électrochimie.

En effet, lorsque l'on utilise un diviseur de courant, comme les deux pistes métalliques selon l'invention, pour générer le champ magnétique à mesurer, il faut que le rapport de division soit indépendant de la température et du niveau de courant. Lorsque le rapport de division est dépendant de la température cela introduit une dérive du gain en température. Lorsque le rapport de division dépend du niveau de courant, cela introduit des non linéarités.

Le capteur de courant selon l'invention permet de mesurer des courants DC et/ou AC. De préférence, les transducteurs à Effet Néel@ sont toutes sensiblement identiques. Les pistes métalliques sont également toutes sensiblement identiques.

En pratique et de façon avantageuse, le capteur de courant selon l'invention peut être utilisé comme transducteur connecté à, et piloté par une unité de traitement. Différents types de connexions et différents types de modes de mesure peuvent être envisagés.

Selon une caractéristique avantageuse de l'invention, le circuit primaire est un conducteur multicouche du circuit imprimé.

Avec l'invention, on améliore la capacité d'intégration du capteur de courant pour un encombrement réduit et on réalise une mesure directement dans un circuit imprimé.

Selon une autre caractéristique avantageuse de l'invention, les bobinages à Effet Néel@ sont des solénoïdes bobinés autour d'un noyau allongé, le tout étant un composant enfoui dans le circuit imprimé.

Pour améliorer encore l'intégration, on prévoit un design de capteur de courant compatible complètement avec une technologie de circuit imprimé. Pour ce faire, on peut envisager que chaque transducteur à Effet Néel@ soit un bobinage plan réalisé dans le circuit imprimé. L'ensemble est disposé dans un même circuit imprimé.

Le noyau est un matériau composite constitué de nanoparticules d'oxydes métalliques dispersées dans une matrice thermoplastique, caoutchouteuse ou rigide, le comportement dudit noyau ainsi constitué étant superparamagnétique à la température d'utilisation.

La matrice est choisie pour ne pas perturber les propriétés magnétiques des nanoparticules. Par exemple, le matériau de la matrice seule est uniquement diamagnétique. De préférence, la matrice est une matière thermodurcissable (e.g., phénoplastes, aminoplastes, résines époxy, polyesters saturés ou insaturés, polyuréthannes linéaires ou réticulés, alkydes), élastomérique (e.g., silicone ou caoutchouc synthétique) ou thermoplastique (e.g., polyvinyliques, chlorures de polyvinyle, acétates de polyvinyle, alcools polyvinyliques, polystyrènes et copolymères, polymères acryliques, polyoléfines, dérivés cellulosiques, polyamides, polymères fluorés, polycarbonates, polyacétals, oxydes de polyphénylènes, polysulfones, polyéthersulfones, polysulfures de phénylène, polyimides). Pour des applications à très haute température la matrice peut aussi être en matière céramique. Suivant les contraintes mécaniques et thermiques subies par le noyau, la matrice peut être armée, par exemple de fibres de verre. Les nanoparticules métalliques peuvent être stabilisées par un agent surfactant, chélatant à son extrémité proximale, comme un acide carboxylique gras, par exemple l'acide oléique, ou un alkylbisphosphonate.

Dans un premier mode de mise en oeuvre, le noyau est préfabriqué aux dimensions d'un logement ménagé dans l'épaisseur du PCB. Par exemple le logement est ménagé par moulage, ou par perçage ou usinage du PCB. La matrice peut alors être constituée de tous les matériaux énumérés précédemment et le composite peut être préfabriqué selon les procédés bien connus de l'homme de l'art.

Dans un deuxième mode de mise en oeuvre, le noyau est fabriqué in situ dans un logement ménagé dans le PCB en utilisant les procédés et équipements dits de « resin filling ». Dans la liste de tous les matériaux énumérés précédemment pour la matrice, l'homme de l'art choisira alors les matériaux compatibles avec les procédés de « resin filling », par exemple les résines bi-composants ou plus généralement à réticulation sous UV ou à la chaleur.

De préférence, chaque noyau superparamagnétique est composé d'une matrice réalisée en résine époxy.

Avantageusement, les quatre transducteurs à Effet Néel@ peuvent constituent deux paires différentielles montées en antiparallèles.

Selon un mode de réalisation avantageux de l'invention, le capteur de courant comprend en outre au moins une paire de transducteurs bobinés sans noyaux magnétiques disposée en différentielle par rapport à une seule des deux pistes métalliques.

Une telle configuration permet de réaliser une mesure combinée DC et AC très large bande. Il est possible de réutiliser les autre bobinages à noyau superparamagnétique pour réaliser une mesure combinée haute fréquence. Cependant pour améliorer les performances en termes de précision, on peut avantageusement utiliser au moins deux bobines supplémentaires, sensiblement identiques et montées en différentielle. Ces bobines ne comportent pas de noyau superparamagnétique et sont localisées à proximité d'un conducteur ne subissant pas l'effet de diviseur.

Selon l'invention, les pistes métalliques peuvent être de largeurs sensiblement identiques réalisées sur une même couche d'un circuit imprimé. Par ailleurs, les pistes métalliques peuvent être d'épaisseurs sensiblement identiques réalisées sur plusieurs couches d'un circuit imprimé.

Les conducteurs subissent l'effet de peau en haute fréquence, ce qui déforme les lignes de courant et rend délicate la mesure de courant alternatif (AC) sauf à utiliser un transformateur de courant classique. La prise en compte de la largeur et de l'épaisseur des pistes métalliques selon l'invention permet de réaliser des mesures avec de fortes variations de courant dI/dt.

Selon un mode de réalisation avantageux de l'invention, les pistes métalliques sont des pistes d'un circuit imprimé réalisées de façon à créer une distribution de champ doublement différentielle.

En particulier, le circuit primaire peut être constitué de deux circuits métalliques réalisés sur une ou plusieurs couches, la forme du second circuit étant obtenue par une opération de symétrie axiale par rapport au premier circuit.

Selon un mode de réalisation de l'invention, le capteur de courant peut comprendre au moins deux circuits primaires faisant face, chaque circuit primaire étant réalisé sur une couche différente du circuit imprimé et constitué de plusieurs pistes métalliques, les transducteurs à Effet Néel@ étant des bobines planes à noyau superparamagnétique disposées entre les deux circuits primaires. Il peut également comprendre deux écrans électrostatiques disposés respectivement sur des couches entre les transducteurs à Effet Néel^{®} et les circuits primaires.

Cela peut consister à intercaler des couches de circuit conducteur entre respectivement les conducteurs primaires et les bobines de mesure.

Selon un mode de réalisation de l'invention, lesdits au moins deux circuits primaires sont parcourus par deux courants différents en étant reliés entre eux à au plus une extrémité. Cela permet de réaliser une mesure différentielle.

Selon un mode de réalisation de l'invention, les pistes métalliques du circuit primaire peuvent être conçues sous forme de spires disposées en série. On peut alors mesurer des courants primaires de plus faible intensité, de 10A, voire 1A, voire 0,1A, voire 10mA, voire 1mA et en dessous.

Selon l'invention, chaque via peut être constitué d'un rivet, d'un tube ou d'un dépôt électrolytique.

Selon un autre aspect de l'invention, il est proposé un procédé pour réaliser un transducteur à effet Néel@ dans un circuit imprimé, lequel procédé comprenant les étapes suivantes :
- réalisation d'un logement dans le circuit imprimé,
- insertion dans logement d'un noyau préfabriqué aux dimensions dudit logement,
- réalisation du bobinage autour du noyau

On peut également prévoir un procédé pour réaliser un transducteur à effet Néel@ dans un circuit imprimé, lequel procédé comprenant les étapes suivantes :
- réalisation d'un logement dans le circuit imprimé en utilisant des techniques dites de « resin filling »,
- insertion dans logement d'un noyau fabriqué in situ,
- réalisation du bobinage autour du noyau.

D'autres avantages et caractéristiques de l'invention apparaîtront à l'examen de la description détaillée d'un mode de mise en oeuvre nullement limitatif, et des dessins annexés, sur lesquels :

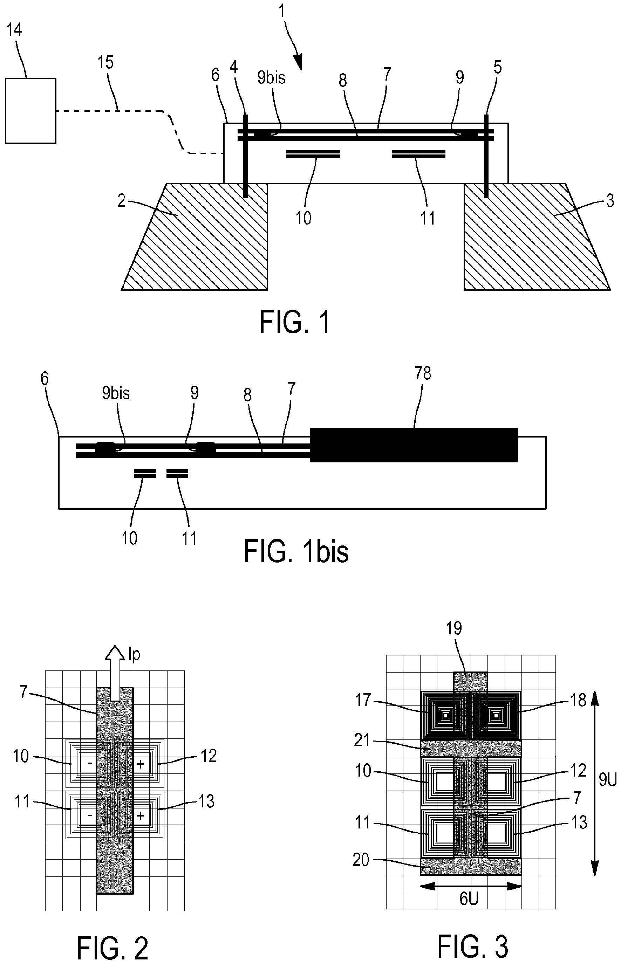

- La figure 1 est une vue schématique du capteur de courant selon l'invention connecté à un conducteur et relié à une unité de traitement,
- La figure 1bis est une vue schématique d'un capteur selon l'invention réalisé sur une ligne d'alimentation 7,8 d'un onduleur de puissance par exemple 78, l'ensemble étant intégré dans un circuit imprimé,
- La figure 2 est une vue de dessus du capteur de courant selon l'invention dans une configuration de mesure différentielle, le courant primaire circule dans le conducteur primaire,
- La figure 3 illustre un exemple de configuration large bande avec quatre bobines à noyau superparamagnétique et deux bobines sans noyau pour la mesure AC,
- La figure 4 illustre un exemple de couche pleine pour laquelle le conducteur est composé de pistes d'un circuit imprimé striées pour améliorer la bande passante du capteur de courant selon l'invention,
- Les figures 5a et 5b illustrent un exemple de structure doublement différentielle monocouche, figure 5a le conducteur primaire et figure 5b les bobinages de mesure,
- Les figures 6a, 6b et 6c illustrent un exemple de structure large bande DC et AC ; figure 6a illustre une première couche primaire qui crée la distribution de champ doublement différentiel dans l'axe des bobinages plans ; figure 6b illustre la seconde couche primaire avec un effet diviseur sur la mesure Néel, qui ne crée pas de champ dans l'axe des bobinages Néel tandis qu'il n'y a pas d'effet diviseur sur les bobines Rogowski ; figure 6c illustre les quatre bobines Néel en bas et les quatre bobines à air en haut,
- La figure 7 est une vue de côté d'un capteur quadripolaire comprenant des écrans électrostatiques selon l'invention,
- La figure 8 est une vue du capteur de la figure 7 avec une connexion des circuits métalliques à une extrémité de façon à former un capteur à trois pôles, et
- La figure 9 est une représentation schématique de deux bobinages plans sur deux couches différentes et connectés en série.

Les modes de réalisation qui seront décrits dans la suite ne sont nullement limitatifs ; on pourra notamment mettre en oeuvre des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont prévus pour être combinés entre eux dans toutes les combinaison où rien ne s'y oppose sur le plan technique.

Sur la figure 1 illustre une vue en coupe d'un capteur de courant 1 connecté à deux conducteurs 2 et 3. Ces conducteurs font partie d'un circuit électrique traversé par un courant à mesurer. Le capteur de courant selon l'invention est utilisé sans aucun connecteur dans un PCB qui intègre d'autres fonctions électroniques (comme un onduleur par exemple), ou bien connecté électriquement aux conducteurs 2 et 3 au moyen de deux attaches métalliques 4 et 5 amovibles qui peuvent être sous forme de vis par exemple. Le capteur de courant constitue de ce fait un pont permettant le passage de courant d'un conducteur à l'autre.

Le capteur de courant 1 est constitué d'un circuit imprimé 6 dans lequel sont réalisées deux pistes métalliques 7 et 8 constituant le circuit primaire par lequel le courant à mesurer passe. Il s'agit de deux pistes de cuivre réalisées dans le circuit imprimé. Elles sont identiques, disposées sur deux couches différentes et reliées entre elles par des via de circuit imprimé 9 et 9bis. Ces via 9 et 9 bis peuvent être des rivets, des tubes ou des dépôts électrolytiques de même métal que les deux pistes et les reliant électriquement sans soudure.

Les dimensions des pistes métalliques dépendent du niveau de courant. Plus le courant est élevé, plus la dimension des pistes métalliques est grande. Toutefois, il est envisagé d'utiliser des densités de courant aux alentours de 5 A/mm² à 10A/mm² sans dépasser une densité de courant de 20A/mm². La largeur dépend également du nombre de couches et de l'épaisseur de cuivre disponible. Pour les gros courants (>100A), on peut mettre en oeuvre un nouveau processus de conception dit « PowerPCB » pour lesquels les épaisseurs de pistes atteignent 200µm, voire 400µm, voire 1mm et au-delà.

On distingue des transducteurs à Effet Néel 10 et 11, c'est-à-dire des bobines à noyau superparamagnétique.

Une unité de traitement 14 est prévue à distance et reliée au capteur de courant par un câble de mesure 15 pour commander les transducteurs à Effet Néel et déterminer la valeur du courant.

Sur la figure 1bis, on distingue un capteur de courant 7,8,9,9bis,10,11 selon l'invention réalisé sur une ligne d'alimentation 7,8 d'un onduleur de puissance 78, l'ensemble étant intégré dans un circuit imprimé. Dans cet exemple, on utilise avantageusement la ligne d'alimentation de l'onduleur intégré pour réaliser une seconde piste et des via. Les transducteurs 10 et 11 permettent de détecter le champ magnétique pour en déduire le courant.

Seules deux bobines 10 et 11 sont représentées, mais deux autres 12 et 13 se trouvent sur la même couche du circuit imprimé dans la profondeur. Les quatre bobines sont des bobines planes visibles sur la figure 2 avec une vue de dessus. La piste métallique 7 est schématiquement illustrée au-dessus des quatre bobines 10, 11, 12 et 13 et véhicule un courant de mesure Ip.

Les quatre bobines sont toutes sensiblement identiques pour permettre une meilleure réjection des perturbations. On peut imaginer une configuration purement différentielle telle que représentée sur la Figure 2 afin de permettre une mesure sur une barre de cuivre classique. Dans cette configuration, le champ magnétique est le même dans les deux bobines de droite 10 et 11, et opposé dans les deux bobines de gauche 12 et 13. Les pistes métalliques ne recouvrent pas les noyaux des bobines qui sont ainsi disposées de part et d'autre.

Le matériau superparamagnétique est placé dans une cavité à l'intérieure des bobines planes.

En ce qui concerne le matériau, on peut considérer deux options de conception:
- on insère un noyau dans le circuit imprimé suivant un principe de composant enfoui « PCB embedded », dans ce cas la matrice du noyau serait soit en composite de type résine epoxy, céramique ou autre,
- on ajoute le noyau dans le circuit imprimé par un procédé de type « resin fill » qui consiste à inclure le matériau directement dans un processus de conception du circuit imprimé classique. Dans ce cas la matrice du noyau serait soit en résine époxy ou autre.

Il est possible de réutiliser les quatre bobinages précédents pour réaliser une mesure combinée haute fréquence. Cependant pour améliorer les performances en termes de précision, on peut avantageusement utiliser au moins deux bobines supplémentaires 17 et 18, sensiblement identiques et montées en différentielle. Ces bobines ne comportent pas de noyau superparamagnétique et sont localisées à proximité d'un conducteur 19 ne subissant pas l'effet de diviseur. Un exemple de solution non limitatif est représenté sur la Figure 3.

On retrouve les quatre bobines à noyau superparamagnétiques 10-13 dans la même configuration que sur la figure 2, avec un circuit primaire à deux pistes dont seule la piste 7 est illustrée. Des moyens de connexion 20 et 21 correspondent aux via 9 et 9bispour assurer la bonne distribution du courant entre les couches.

Le conducteur 19 est unique et complète le circuit primaire véhiculant le courant à mesurer. Ce conducteur 19 est relié à l'ensemble des deux pistes 7 et 8. En particulier il peut s'agir de la continuité d'une des deux pistes. Les conducteurs 2 et 3 seront donc respectivement connectés d'une part au conducteur 19 et d'autre part aux deux pistes 7 et 8.

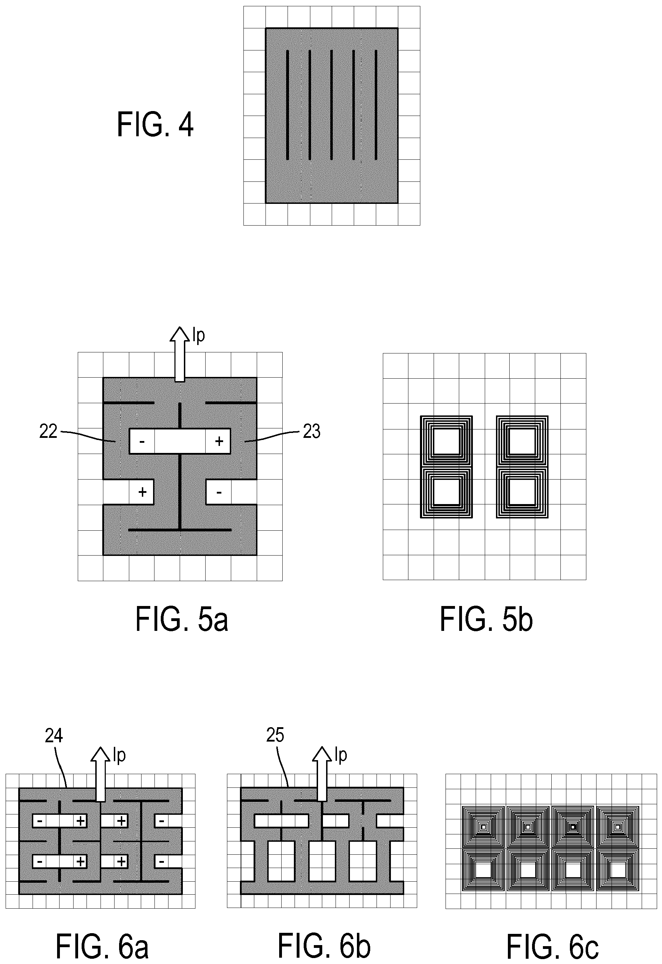

Dans une configuration avantageuse de la solution, et notamment pour réduire les phénomènes d'effet de peau qui peuvent réduire la bande passante du capteur, le circuit ou conducteur primaire est composé de plusieurs pistes de circuit imprimé de même largeur et de même épaisseur. Ces pistes peuvent être alors placées parallèlement les unes aux autres sur une même couche de circuit imprimé comme illustré sur la Figure 4, ou bien superposées sur plusieurs couches, ou bien les deux ; pour chaque piste il faut prévoir une seconde piste avec laquelle elle est reliée au moyen au moins de deux via.

Pour avoir une réjection efficace des champs externes, on peut avantageusement utiliser une structure doublement différentielle pour améliorer la réjection des champs externes. Dans ce cas, la forme du conducteur primaire est adaptée pour générer une distribution de champs compatible avec la structure doublement différentielle et des bobinages de mesure de forme plane par exemple. Un exemple de réalisation est illustré sur les figures 5a et 5b. Sur la figure 5a, le circuit primaire est constitué de deux circuits métalliques 22 et 23 réalisés sur une même couche, la forme du second circuit 23 étant obtenue par une opération de symétrie axiale par rapport au premier circuit 22. A titre d'exemple, le circuit de la figure 4 peut avantageusement servir de secondes pistes reliées aux circuits de la figure 5a par des via, les ronds sur les deux figures.

Dans le cas présent, le premier circuit métallique 22 présente une forme globalement en serpentin ou en « S », l'association des premier et second circuits métalliques 22 et 23 laisse apparaître des zones non recouverte dans le circuit imprimé. Ces zones sont symbolisées par des signes « + » et « - » représentant l'orientation et le positionnement des axes des champs magnétiques créés par des bobines à noyau superparamagnétique disposées sur une autre couche du circuit imprimé. Ces bobines sont représentées sur la figure 5b et constituent deux paires différentielles montées en antiparallèles.

Cette topologie peut avantageusement être utilisée pour les mesures par Effet Néel@ et Rogowski, avec huit bobines planes, dont quatre chargées de noyaux superparamagnétiques et quatre à air (sans noyau superparamagnétique).

De façon préférentielle, on n'utilise pas d'effet diviseur au niveau des bobines à air afin d'améliorer la bande passante et la sensibilité. Un exemple de réalisation DC et AC à très large bande est représenté sur les figures 6a, 6b et 6c. Sur la figure 6a, on distingue une première couche primaire 24 qui crée la distribution de champ doublement différentiel dans l'axe des bobinages plans. Cette première couche est constituée de quatre circuits métalliques qui sont symétriques deux par deux.

Sur la figure 6b une seconde couche primaire 25 avec un effet diviseur sur la mesure Néel qui ne crée pas de champ dans l'axe des bobines à noyau superparamagnétique, tandis qu'il n'y a pas d'effet diviseur sur les bobines Rogowski (à air). Cette deuxième couche est constituée de quatre circuits métalliques qui sont symétriques deux par deux.

Sur les figures 6a et 6b, les via permettant la distribution du courant entre les deux couches sont les petits ronds répartis sur les deux couches.

Sur la figure 6c, les quatre bobines à noyau superparamagnétique en bas et les quatre bobines à air en haut.

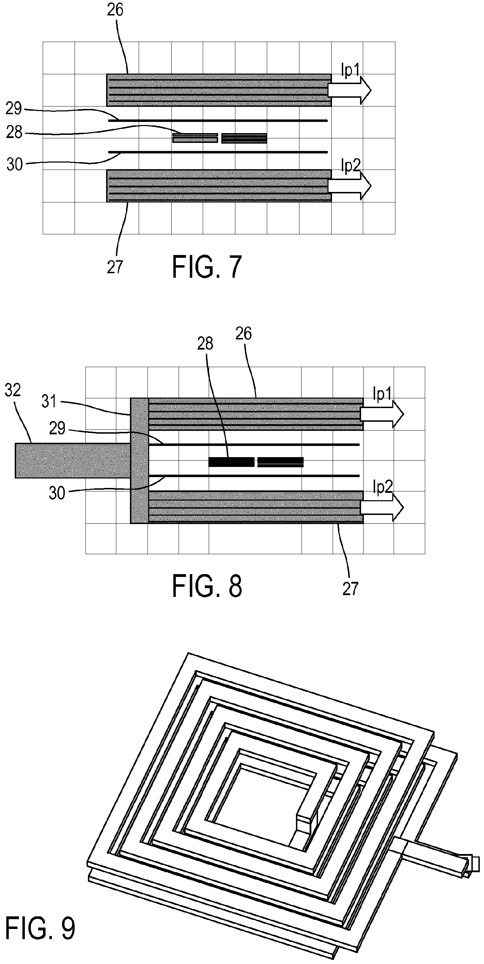

Selon l'invention, le conducteur primaire peut avantageusement être constitué de plusieurs pôles afin de réaliser un capteur plus linéaire ou différentiel. Par exemple sur la figure 7, un premier pôle positif 26 situé dans un plan supérieur à celui des bobinages de mesure 28 et un second pôle négatif 27 situé dans un plan inférieur à celui des bobines de mesure. L'épaisseur du matériau isolant placé entre les pôles primaires 26, 27 et les bobinages de mesure 28 peut être ajustée en fonction de la tension d'isolement recherchée. Cette épaisseur peut être avantageusement constituée de couches diélectriques pour améliorer la tenue en tension. Il peut également être avantageusement introduit une couche conductrice 29, 30 entre les pôles primaire 26, 27 et les bobinages 28 afin de constituer un écran électrostatique de type cage de Faraday. Ainsi, la Figure 7 montre une configuration quadripolaire avec deux courants Ip1 et Ip2 et deux écrans électrostatiques 29 et 30. Le capteur peut être dessiné de telle sorte que les champs magnétiques généré par les courant Ip1 et Ip2 aux niveaux des bobines de mesure soient constructifs ou destructifs. On peut ainsi décider de réaliser un capteur de courant de mode commun ou différentiel. Dans une combinaison avantageuse, on peut utiliser la combinaison constructive pour améliorer la linéarité du capteur. En effet, on améliore l'homogénéité du champ dans les bobines de mesure, ce qui permet d'améliorer la linéarité du capteur. Dans cette combinaison, on utilise alors d'autres Via pour relier les conducteurs des pôles 26 et 27. Dans une autre combinaison avantageuse, on peut mesurer simultanément les f.e.m aux bornes des bobinages à air connectés en mode commun ou différentiel afin de constituer un capteur « 2 en 1 » qui mesure la composante alternative du courant primaire de mode commun et de mode différentiel.

Sur la figure 8, deux extrémités des circuits 26 et 27 sont reliées entre elles au moyen du via 31, de façon à constituer au moins trois pôles, 26, 27 et 32 (piste métallique) et permettre une mesure différentielle et/ou de mode commun.

Le principe ci-dessus peut être adapté à la mesure de différence de potentiels isolée. Pour cela, on utilise un principe qui consiste à dériver un petit courant via un résistor de forte résistance et via un capteur de courant selon l'invention. Il est alors avantageux d'utiliser le circuit primaire pour constituer un grand nombre de spires mises en série et non pas en parallèle afin d'amplifier l'intensifier le champ magnétique à mesurer dans les bobinages. Une configuration des spires en série est représentée sur la figure 9. Le champ au coeur de la bobine est proportionnel au courant que multiplie le nombre de spires/couches et que multiplie le nombre de couches.

Bien sûr, l'invention n'est pas limitée aux exemples qui viennent d'être décrits et de nombreux aménagements peuvent être apportés à ces exemples sans sortir du cadre de l'invention. Le capteur de courant selon l'invention peut complètement être intégré dans un circuit imprimé et être utilisé pour mesurer un courant d'un dispositif électronique également réalisé dans le circuit imprimé. Par exemple, le dispositif électronique peut être un onduleur réalisé sur un circuit imprimé, le capteur de courant selon l'invention étant conçu à partir de deux pistes d'une sortie d'une phase de l'onduleur. Le capteur de courant selon l'invention peut être conçu à partir de deux pistes métalliques de tout circuit d'alimentation d'un circuit imprimé.

## Revendications

1. Capteur de courant comprenant au moins un circuit primaire (7, 8) destiné à conduire le courant à mesurer, et un circuit secondaire comprenant au moins quatre transducteurs à Effet Néel (10, 11, 12, 13) constitués chacun d'un bobinage et d'un noyau superparamagnétique, **caractérisé en ce qu'**il est conçu à base de circuit imprimé, le circuit primaire (7, 8) comprenant au moins de ux pistes métalliques distinctes composées d'un même métal et connectées entre elles para u moins deux via (9, 9bis) constitués du même métal que les pistes métalliques.

2. Capteur selon la revendication 1, **caractérisé en ce que** le circuit primaire (7, 8) est un conducteur multicouche du circuit imprimé.

3. Capteur selon la revendication 1 ou 2, **caractérisé en ce que** les bobinages à Effet Néel sont des solénoïdes bobinés autour d'un noyau allongé, le tout étant un composant enfoui dans le circuit imprimé.

4. Capteur selon la revendication 1 ou 2, **caractérisé en ce que** chaque transducteur à Effet Néel est un bobinage plan réalisé dans le circuit imprimé.

5. Capteur selon la revendication 1 ou 2, **caractérisé en ce qu'**il comprend au moins deux circuits primaires faisant face, chaque circuit primaire étant réalisé sur une couche différente du ci rcuit imprimé et constitué de plusieurs pistes métalliques, les transducteurs à Effet Néel étant des bobines planes à noya u superparamagnétique disposées entre les deux circuits primaires ; et **en ce qu'**il comprend en outre deux écrans électrostatiques disposés respectivement sur des couches entre les transducteurs à Effet Néel et les circuits primaires.

6. Capteur selon la revendication 5, **caractérisé en ce que** lesdits au moins deux circuits primaires sont reliés entre euxà au plus une extrémité.

7. Capteur selon l'une quelconque des revendications précédentes, **caractérisé en ce que** chaque noyau superparamagnétique est composé d'une matrice réalisée en résine époxy.

8. Capteur selon l'une quelconque des revendications précédentes, **caractérisé en ce que** les quatre transducteurs à Effet Néel^{®} (10, 11, 12, 13) constituent deux paires différentielles montées en antiparallèles.

9. Capteur selon l'une quelconque des revendications précédentes, **caractérisé en ce que** les pistes métalliques sont de largeurs sensiblement identiques réalisées sur une même couche d'un circuit imprimé.

10. Capteur selon l'une quelconque des revendications précédentes, **caractérisé en ce que** les pistes métalliques sont d'épaisseurs sensiblement identiques réalisées surplusieurs couches d'un circuit imprimé.

11. Capteur selon l'une quelconque des revendications précédentes, **caractérisé en ce que** les pistes métalliques sont des pistes d'un circuit imprimé réalisées de façon à créer une distribution de champ doublement différentielle.

12. Capteur selon la revendication 11, **caractérisé en ce que** le circuit primaire est constitué de deux ci rcuits métalliques réalisés sur une ou plusieurs couches, la forme du second ci rcuit étant obtenue par une opération de symétrie axiale parrapportau premiercircuit.

13. Capteur selon l'une quelconque des revendications précédentes, **caractérisé en ce que** les pistes métalliques du circuit primaire sont conçues sous forme despires disposées en série.

14. Capteur selon l'une quelconque des revendications précédentes, **caractérisé en ce que** chaque via est constitué d'un rivet, d'un tube ou d'un dépôt électrolytique.

15. Procédé pour réaliser dans un circuit imprimé un transducteur à effet Néel du circuit secondaire d'un capteur de courant selon l'une quelconque des revendications 1 à 14, lequel procédé comprenant les étapes suivantes:
- réalisation d'un logement dans le circuit imprimé,
- insertion dans le logement d'un noyau préfabriqué aux dimensions dudit logement,
- réalisation du bobinage autour du noyau.

16. Procédé pour réaliser dans un circuit imprimé un transducteur à effet Néel du circuit secondaire d'un capteur de courant selon l'une quelconque des revendications 1 à 14, lequel procédé comprenant les étapes suivantes:
- réalisation d'un logement dans le circuit imprimé en utilisant des techniques dites de « resin filling »,
- insertion dans le logement d'un noyau fabriqué in situ,
- réalisation du bobinage autour du noyau.

## Patentansprüche

1. Stromsensor, der mindestens eine Primärschaltung (7, 8), die dazu bestimmt ist, den zu messenden Strom zu leiten, und eine Sekundärschaltung umfasst, welche mindestens vier Néel-Effekt-Wandler (10, 11, 12, 13) umfasst, die jeweils aus einer Wicklung und einem superparamagnetischen Kern bestehen, **dadurch gekennzeichnet, dass** er auf Basis einer Leiterplatte konzipiert ist, wobei die Primärschaltung (7, 8) mindestens zwei getrennte Metallbahnen umfasst, die aus demselben Metall bestehen und über mindestens zwei Durchkontaktierungen (9, 9bis), die aus demselben Metall wie die Metallbahnen bestehen, miteinander verbunden sind.

2. Sensor nach Anspruch 1, **dadurch gekennzeichnet, dass** die Primärschaltung (7, 8) ein mehrschichtiger Leiter der Leiterplatte ist.

3. Sensor nach Anspruch 1 oder 2, **dadurch gekennzeichnet, dass** die Néel-Effekt-Wicklungen um einen länglichen Kern gewickelte Solenoiden sind, wobei das Ganze eine in der Leiterplatte eingebettete Komponente ist.

4. Sensor nach Anspruch 1 oder 2, **dadurch gekennzeichnet, dass** jeder Néel-Effekt-Wandler eine Flachwicklung ist, die in der Leiterplatte hergestellt ist.

5. Sensor nach Anspruch 1 oder 2, **dadurch gekennzeichnet, dass** er mindestens zwei einander zugewandte Primärschaltungen umfasst, wobei jede Primärschaltung auf einer anderen Schicht der Leiterplatte hergestellt ist und aus mehreren Metallbahnen besteht, wobei die Néel-Effekt-Wandler Flachspulen mit superparamagnetischem Kern sind, die zwischen den zwei Primärschaltungen angeordnet sind; und dadurch, dass er weiter zwei elektrostatische Abschirmungen umfasst, die jeweils auf Schichten zwischen den Néel-Effekt-Wandlern und den Primärschaltungen angeordnet sind.

6. Sensor nach Anspruch 5, **dadurch gekennzeichnet, dass** die mindestens zwei Primärschaltungen an höchstens einem Ende miteinander verbunden sind.

7. Sensor nach einem der vorstehenden Ansprüche, **dadurch gekennzeichnet, dass** jeder superparamagnetische Kern aus einer Matrix besteht, die aus Epoxidharz hergestellt ist.

8. Sensor nach einem der vorstehenden Ansprüche, **dadurch gekennzeichnet, dass** die vier Néel-Effekt^{®}-Wandler (10, 11, 12, 13) zwei antiparallel montierte Differentialpaare bilden.

9. Sensor nach einem der vorstehenden Ansprüche, **dadurch gekennzeichnet, dass** die Metallbahnen im Wesentlichen gleiche Breiten haben, die auf derselben Schicht einer Leiterplatte hergestellt sind.

10. Sensor nach einem der vorstehenden Ansprüche, **dadurch gekennzeichnet, dass** die Metallbahnen im Wesentlichen gleiche Dicken haben, die auf mehreren Schichten einer Leiterplatte hergestellt sind.

11. Sensor nach einem der vorstehenden Ansprüche, **dadurch gekennzeichnet, dass** die Metallbahnen Bahnen einer Leiterplatte sind, die so hergestellt sind, dass sie eine doppelt differentielle Feldverteilung erzeugen.

12. Sensor nach Anspruch 11, **dadurch gekennzeichnet, dass** die Primärschaltung aus zwei Metallschaltungen besteht, die auf einer oder mehreren Schichten hergestellt sind, wobei die Form der zweiten Schaltung durch eine in Bezug auf die erste Schaltung axialsymmetrische Operation erhalten wird.

13. Sensor nach einem der vorstehenden Ansprüche, **dadurch gekennzeichnet, dass** die Metallbahnen der Primärschaltung in Form von in Reihe angeordneten Windungen konzipiert sind.

14. Sensor nach einem der vorstehenden Ansprüche, **dadurch gekennzeichnet, dass** jede Durchkontaktierung aus einem Niet, einem Rohr oder einer elektrolytischen Abscheidung besteht.

15. Verfahren zum Herstellen eines Néel-Effekt-Wandlers der Sekundärschaltung eines Stromsensors nach einem der Ansprüche 1 bis 14 in einer Leiterplatte, wobei das Verfahren die folgenden Schritte umfasst:
- Herstellen einer Aufnahme in der Leiterplatte,
- Einsetzen eines vorgefertigten Kerns mit den Abmessungen der Aufnahme in die Aufnahme,
- Herstellen der Wicklung um den Kern.

16. Verfahren zum Herstellen eines Néel-Effekt-Wandlers der Sekundärschaltung eines Stromsensors nach einem der Ansprüche 1 bis 14 in einer Leiterplatte, wobei das Verfahren die folgenden Schritte umfasst:
- Herstellen einer Aufnahme in der Leiterplatte unter Verwendung von sogenannten "Resin Filling"-Techniken,
- Einsetzen eines in situ gefertigten Kerns in die Aufnahme,
- Herstellen der Wicklung um den Kern.

## Claims

1. A current sensor comprising: at least one primary circuit (7, 8) intended to conduct the current to be measured, and a secondary circuit comprising at least four Neel Effect transducers (10, 11, 12, 13) each constituted by a coil and a superparamagnetic core, **Characterized in that** said sensor is designed on the basis of a printed circuit, the primary circuit (7, 8) comprising at least two distinct metal tracks composed of one and the same metal and connected together by at least two vias (9, 9bis) constituted by the same metal as the metal tracks.

2. The sensor according to claim 1, **characterized in that** the primary circuit (7, 8) is a multilayer conductor of the printed circuit.

3. The sensor according to claim 1 or 2, **characterized in that** the Neel Effect coils are solenoids wound round an elongated core, the whole being a component embedded in the printed circuit.

4. The sensor according to claim 1 or 2, **characterized in that** each Neel Effect transducer is a flat coil produced in the printed circuit.

5. The sensor according to claim 1 or 2, **characterized in that** it comprises at least two primary circuits facing one another, each primary circuit being produced on a different layer of the printed circuit and consisting of several metal tracks, the Neel Effect transducers being flat coils with a superparamagnetic core arranged between the two primary circuits; and **in that** it further comprises two electrostatic screens arranged respectively on layers between the Neel Effect transducers and the primary circuits.

6. The sensor according to claim 5, **characterized in that** said at least two primary circuits are connected together at one end.

7. The sensor according to any of the preceding claims, **characterized in that** each superparamagnetic core is composed of a matrix produced from epoxy resin.

8. The sensor according to any of the preceding claims, **characterized in that** the four Neel Effect^{®} transducers (10, 11, 12, 13) constitute two antiparallel-mounted differential pairs.

9. The sensor according to any of the preceding claims, **characterized in that** the metal tracks are of substantially identical widths produced on one and the same layer of a printed circuit.

10. The sensor according to any of the preceding claims, **characterized in that** the metal tracks are of substantially identical thicknesses produced on several layers of a printed circuit.

11. The sensor according to any of the preceding claims, **characterized in that** the metal tracks are tracks of a printed circuit produced so as to create a double-differential field distribution.

12. The sensor according to claim 11, **characterized in that** the primary circuit is constituted by two metal circuits produced on one or more layers, the shape of the second circuit being obtained by an operation of axial symmetry with respect to the first circuit.

13. The sensor according to any of the preceding claims, **characterized in that** the metal tracks of the primary circuit are designed in the form of turns arranged in series.

14. The sensor according to any of the preceding claims, **characterized in that** each via consists of a rivet, a tube or an electrolytic deposit.

15. A method for producing, in a printed circuit, a Neel Effect transducer of the secondary circuit of a current sensor according to any of claims 1 to 14, said method comprising the following steps:
- producing a housing in the printed circuit;
- inserting, in the housing, a core prefabricated to the dimensions of said housing; and
- producing the coil round the core.

16. A method for making in a printed circuit a Neel Effect transducer of the secondary circuit of a current sensor according to any of claims 1 to 14, said method comprising the following steps:
- producing a housing in the printed circuit using techniques known as "resin filling";
- inserting a core, fabricated *in situ,* into the housing; and
- producing the coil round the core.
